**Europäisches Patentamt**

**European Patent Office**

**Office européen des brevets**

(11) **EP 4 726 916 A1**

(12) **EUROPEAN PATENT APPLICATION**
published in accordance with Art. 153(4) EPC

(43) Date of publication:
**15.04.2026 Bulletin 2026/16**

(21) Application number: **24861446.3**

(22) Date of filing: **02.02.2024**

(51) International Patent Classification (IPC):
*H01Q 1/20* (2006.01)   *H01Q 1/22* (2006.01)
*H01Q 1/24* (2006.01)

(86) International application number:
**PCT/CN2024/075496**

(87) International publication number:
**WO 2025/050595 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **07.09.2023   CN 202311146409**

(71) Applicant: **Honor Device Co., Ltd.
Shenzhen, Guangdong 518040 (CN)**

(72) Inventor: **HU, Wenlong
Shenzhen, Guangdong 518040 (CN)**

(74) Representative: **Gill Jennings & Every LLP
The Broadgate Tower
20 Primrose Street
London EC2A 2ES (GB)**

(54) **ELECTRONIC APPARATUS**

(57)     This application discloses an electronic device. The electronic device includes a metal frame antenna component, a metal component, and a tuning component. A spacing exists between the metal component and the metal frame antenna component. The tuning component includes an equivalent device region and a plurality of welding regions. The plurality of welding regions are separately located on two ends of the equivalent device region. The welding region on one end of the equivalent device region is welded to the metal frame antenna component, and the welding region on the other end of the equivalent device region is welded to the metal component. The equivalent device region and the welding regions are integrally disposed. In this application, the welding regions are separately disposed on the two ends of the equivalent device region, so that the tuning component can be directly welded to the metal frame antenna component and the metal component through the welding regions. This has a simple connection structure, occupies small space, and facilitates a compact design of the electronic device.

FIG. 6

EP 4 726 916 A1

Processed by Luminess, 75001 PARIS (FR)

# Description

This application claims priority to Chinese Patent Application No. "202311146409.X", filed with the China National Intellectual Property Administration on September 7, 2023 and entitled "ELECTRONIC DEVICE", which is incorporated herein by reference in its entirety.

## TECHNICAL FIELD

This application relates to the field of antenna structure technologies in an electronic device, and specifically, to an electronic device.

## BACKGROUND

In the conventional technologies, for ease of transmitting or receiving a signal, an antenna usually needs to be disposed in an electronic device (for example, a mobile phone, a tablet, or a watch), and a component (a capacitor or an inductor) is usually disposed in an antenna slot (a spacing between two antenna components) or an antenna slot location (a spacing between an antenna component and a metal component), to tune the antenna by using the component. However, an existing tuning solution of disposing the component in the antenna slot or the antenna slot location features large occupied space, a complex electrical connection form, a small antenna clearance, and high costs.

## SUMMARY

To overcome the foregoing problems existing in the conventional technologies, a main purpose of this application is to provide an electronic device occupying small space and facilitating a compact design.

To achieve the foregoing objective, the following technical solutions are specifically used in this application.

This application provides an electronic device. The electronic device includes:

a metal frame antenna component;
a metal component, where a spacing exists between the metal component and the metal frame antenna component; and
a tuning component, where the tuning component includes an equivalent device region and a plurality of welding regions, the plurality of welding regions are separately located on two ends of the equivalent device region, the welding region on one end of the equivalent device region is welded to the metal frame antenna component, and the welding region on the other end of the equivalent device region is welded to the metal component, and
the equivalent device region and the welding regions are integrally disposed.

In this embodiment, the welding regions are separately disposed on the two ends of the equivalent device region, so that the tuning component can be directly welded to the metal frame antenna component and the metal component through the welding regions. This has a simple connection structure, occupies small space, and facilitates a compact design of the electronic device.

In some embodiments, the welding region on the end of the equivalent device region is further connected to the metal frame antenna component through adhesion, and the welding region on the other end of the equivalent device region is further connected to the metal component through adhesion. In this embodiment, the welding regions are further connected to the metal frame antenna component and the metal component through adhesion, so that the tuning component can be more stably connected to the metal frame antenna component and the metal component.

In some embodiments, the equivalent device region and the welding region each include a metal layer and an anti-oxidation layer that are laminated, and the anti-oxidation layer is disposed on a side that is of the metal layer and that faces away from the metal frame antenna component and the metal component. In this embodiment, the anti-oxidation layer is disposed, to prevent, by using the anti-oxidation layer, the metal layer from being oxidated due to exposure to the air.

In some embodiments, the equivalent device region and the welding region each further include a strengthening layer, and the strengthening layer is disposed on a side that is of the metal layer and that faces the metal frame antenna component and the metal component. In this embodiment, the strengthening layer is disposed, to improve reliability of the tuning component by using the strengthening layer.

In some embodiments, a welding position is disposed in the welding region. At the welding position, the side that is of the metal layer and that faces the anti-oxidation layer can be exposed outside the anti-oxidation layer through the welding position, and the side that is of the metal layer and that faces the strengthening layer can be exposed outside the strengthening layer through the welding position. In this embodiment, the welding position is disposed in the welding region to make way for a welding tip, so that the welding tip can be put through the welding position and weld the metal layer, the metal frame antenna component, and the metal component, thereby improving welding effect.

In some embodiments, there are a plurality of welding positions, and the plurality of welding positions are spaced along a length extension direction of the equivalent device region. In this embodiment, the plurality of welding positions are disposed, so that the tuning component is welded to the metal frame antenna component and the metal component by using the plurality of welding positions, thereby improving welding stability of the tuning component and each of the metal frame antenna component and the metal component. In this way, electrical connection stability of the tuning component and each of the metal frame antenna component and the metal component is ensured.

In some embodiments, the strengthening layer is connected to one side of the metal layer through adhesion, and the anti-oxidation layer is connected to the other side of the metal layer through adhesion. In this embodiment, the strengthening layer and the anti-oxidation layer are respectively connected to the two opposite sides of the metal layer through adhesion, so that a connection between the metal layer and each of the strengthening layer and the anti-oxidation layer is more stable.

In some embodiments, a material of the anti-oxidation layer is a thin polyester film or ink; or

> a material of the metal layer is copper foil, aluminum foil, silver foil, or gold foil; or
> a material of the strengthening layer is polyimide, a thin polyester film, or fiberglass cloth.

In some embodiments, the welding region is welded to the metal frame antenna component or the metal component through ultrasonic welding, spot welding, or laser filling.

In some embodiments, the equivalent device region can be equivalent to a capacitor or an inductor. In this embodiment, a resonance frequency of an antenna is adjusted by using a capacitor or an inductor. This adjustment manner is simple.

Correspondingly, this application further provides another electronic device. The electronic device includes:

> a metal frame antenna component;
> a metal component, where a spacing exists between the metal component and the metal frame antenna component; and
> a tuning component, where the tuning component includes an equivalent device region and a plurality of welding regions, the plurality of welding regions are separately located on two ends of the equivalent device region, the welding region on one end of the equivalent device region is welded to the metal frame antenna component, and the welding region on the other end of the equivalent device region is welded to the metal component, and
> the tuning component includes a silver paste layer.

In this embodiment, the welding regions are separately disposed on the two ends of the equivalent device region, so that the tuning component can be directly welded to the metal frame antenna component and the metal component through the welding regions. This has a simple connection structure, occupies small space, and facilitates a compact design of the electronic device.

In some embodiments, the welding region is welded to the metal frame antenna component and the metal component through pad printing or spraying. In this embodiment, the welding region is welded to the metal frame antenna component and the metal component through pad printing or spraying. A manufacturing process is simple.

In some embodiments, the welding region on the end of the equivalent device region is further connected to the metal frame antenna component through adhesion, and the welding region on the other end of the equivalent device region is further connected to the metal component through adhesion. In this embodiment, the welding regions are further connected to the metal frame antenna component and the metal component through adhesion, so that the tuning component can be more stably connected to the metal frame antenna component and the metal component.

In some embodiments, the equivalent device region can be equivalent to a capacitor or an inductor. In this embodiment, a resonance frequency of an antenna is adjusted by using a capacitor or an inductor. This adjustment manner is simple.

In some embodiments, when the equivalent device region is equivalent to an inductor, a silver paste layer of the equivalent device region is disposed as a silver paste wiring.

In some embodiments, a corresponding shape of the silver paste wiring is formed by using a customized-shape indenter, or a corresponding shape of the silver paste wiring is formed by removing an excessive region of the entire silver paste layer through laser carving.

In some embodiments, when the equivalent device region is equivalent to a capacitor, the tuning component further includes a dielectric layer. A plurality of silver paste layers are disposed. The dielectric layer is disposed between the silver paste layers.

Different from the conventional technologies, the electronic device in this application includes the metal frame antenna component, the metal component, and the tuning component. The spacing exists between the metal component and the metal frame antenna component. The tuning component includes the equivalent device region and the plurality of welding regions. The plurality of welding regions are separately located on the two ends of the equivalent device region. The welding region on one end of the equivalent device region is welded to the metal frame antenna component, and the welding region on the other end of the equivalent device region is welded to the metal component. The equivalent device region and the welding regions are integrally disposed. In this embodiment, the welding regions are separately disposed on the two ends of the equivalent device region, so that the tuning component can be directly welded to the metal frame antenna component and the metal component through the welding regions. This has a simple connection structure, occupies small space, and facilitates a compact design of the electronic device.

## BRIEF DESCRIPTION OF DRAWINGS

The accompanying drawings herein are incorporated into this specification and constitute a part of this specification, show embodiments conforming to this application, and are used together with this specification to explain a principle of this application.

FIG. 1 is a diagram of a structure of a tuning point and a feedpoint that are disposed between a reference ground and a middle frame in an electronic device according to the conventional technologies;
FIG. 2 is a partial sectional view of an electronic device according to the conventional technologies;
FIG. 3 is a diagram of a structure of a tuning member that is disposed between a middle frame and a battery in an electronic device according to the conventional technologies;
FIG. 4 is a diagram of a structure of a connection between a metal frame antenna and a flexible circuit board in an electronic device according to the conventional technologies;
FIG. 5 is a sectional view of FIG. 4;
FIG. 6 is a diagram of a structure of a connection between a metal component and a tuning component in an electronic device according to an embodiment of this application;
FIG. 7 is a sectional view of FIG. 6;
FIG. 8 is a top view of a tuning component in an electronic device according to an embodiment of this application;
FIG. 9 is a sectional view of FIG. 8 along A-A;
FIG. 10 is a sectional view of FIG. 8 along B-B;
FIG. 11 is a diagram of a structure of a metal layer;
FIG. 12(a) and FIG. 12(b) each are a diagram of a structure of an equivalent device region at a metal layer according to another embodiment of this application;
FIG. 13 shows a process of manufacturing a connection between a metal frame antenna and a flexible circuit board in an electronic device according to the conventional technologies;
FIG. 14 shows a process of manufacturing a connection between a metal component and a tuning component in an electronic device according to an embodiment of this application;
FIG. 15 is a diagram of a structure of a connection between a metal component and a tuning component in an electronic device according to another embodiment of this application;
FIG. 16 is a sectional view of FIG. 15;
FIG. 17 is a sectional view of a connection between a metal component and a tuning component in an electronic device according to still another embodiment of this application; and
FIG. 18 is a sectional view of a connection between a metal component and a tuning component in an electronic device according to yet another embodiment of this application.

Reference numerals:

1: metal frame antenna component; 2: metal component; 3: tuning component; 31: anti-oxidation layer; 32: metal layer; 33: strengthening layer; 34: back adhesive; 3a: equivalent device region; 3b: welding region; 3c: welding position; 35: silver paste layer; 36: dielectric layer; 4: insulating double-sided adhesive; 5: injection molded piece; 6: welding tip; 101: middle frame; 102: reference ground; 103: circuit board; 104: elastic piece; 105: injection molded piece; 201: battery; 202: side plate; 203: circuit board; 204: tuning member; 205: middle frame; 206: elastic piece; 301: first metal frame antenna; 301a: first connection region; 302: second metal frame antenna; 302a: second connection region; 303: flexible circuit board; 303a: tuning part; 303b: redundancy part; 304: connection plate; 305: injection molded piece.

## DESCRIPTION OF EMBODIMENTS

To make the objectives, technical solutions, and advantages of this application clearer, this application is further described in detail below with reference to the accompanying drawings and embodiments. It should be understood that embodiments described in this specification are merely intended to explain this application, but not to limit this application.

In the descriptions of this application, unless otherwise specified and defined explicitly, the terms "first" and "second" are merely intended for the purpose of description, and shall not be understood as an indication or implication of relative importance; unless otherwise specified or stated, the term "a plurality of" means two or more; and the terms such as "connection" and "fastening" should be understood in a broad sense. For example, the "connection" may be a fixed connection, a detachable connection, an integrated connection, or an electrical connection; or may be a direct connection or an indirect connection through an intermediate medium. A person of ordinary skill in the art may understand specific meanings of the foregoing terms in this application according to specific situations.

In the descriptions of this specification, it should be understood that the directional words such as "on" and "under" described in embodiments of this application are described from perspectives shown in the accompanying drawings, and shall not be understood as a limitation on embodiments of this application. In addition, in the context, it should also be understood that when an element is referred to as being connected "on" or "under" another element, it can be directly connected "on" or "under" the another element, or be indirectly connected "on" or "under" the another element through an intermediate element.

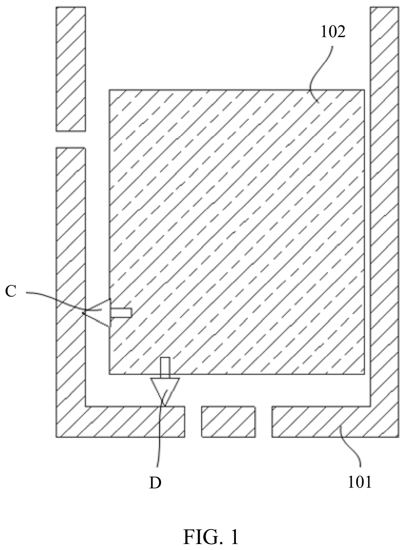

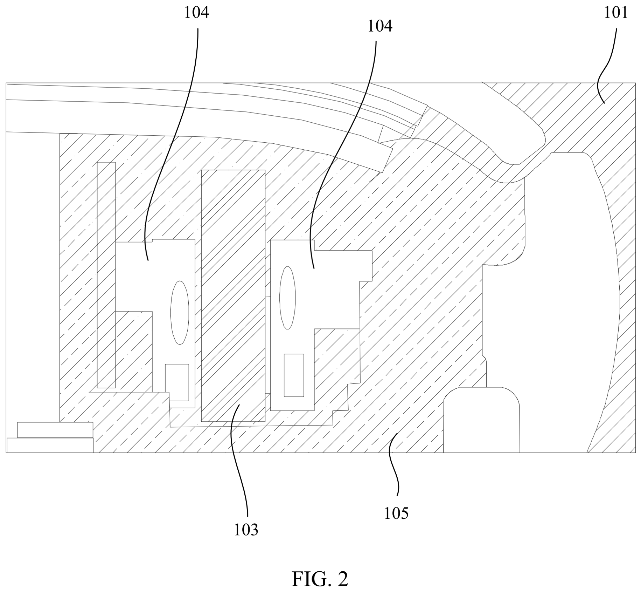

The electronic device usually includes a battery case, a middle frame, and a screen. The battery case and the screen are connected to two sides of the middle frame, to form an accommodating cavity that can be used to accommodate a battery, a circuit board, and an electronic component. An antenna and the middle frame are integrally disposed. Therefore, the middle frame may be usually referred to as an antenna radiator. A tuning point and a feedpoint may be usually disposed between the middle frame 101 and a reference ground 102 of the electronic device (that is, an inductor or a capacitor is disposed between the middle frame and the reference ground of the electronic device), to tune the antenna radiator by using the tuning point C and the feedpoint D. With reference to FIG. 1, FIG. 1 is a diagram of a structure of a tuning point and a feedpoint that are disposed between a reference ground and a middle frame in an electronic device according to the conventional technologies. In an actual application scenario, an injection molded piece 105, a circuit board 103, and elastic pieces 104 are disposed in the middle frame 101, and a tuning member is disposed on the circuit board 103. In addition, one side of the circuit board 103 is connected to the middle frame 101 through the elastic piece 104, and the other side of the circuit board 103 is connected to the reference ground through the elastic piece 104 (an abutting structure between each of the elastic pieces and each of the middle frame and the reference ground is not shown in FIG. 2). With reference to FIG. 2, FIG. 2 is a partial sectional view of an electronic device according to the conventional technologies.

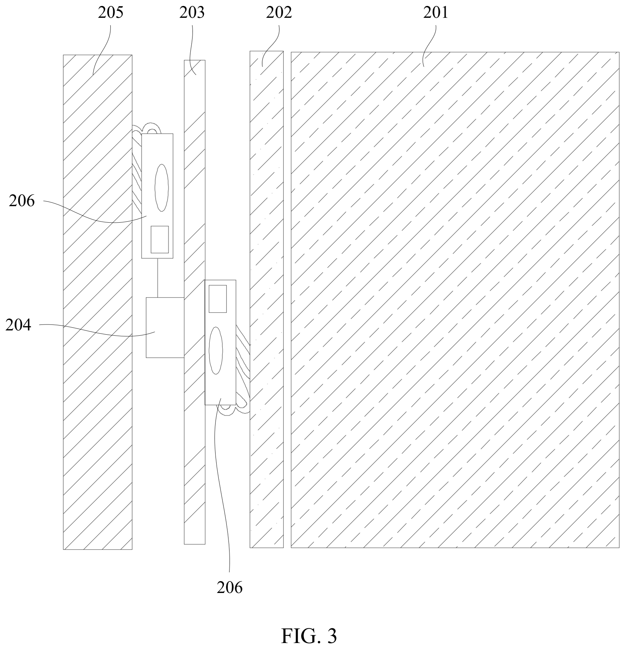

An electronic device is provided according to the conventional technologies. The electronic device has an LB C-mode antenna. A small inductor (0 NH to 1.5 NH) needs to be set for the LB C-mode antenna to return to the ground. Currently, a common solution in the industry is using a side plate. To be specific, antenna backflow is implemented by inserting the side plate at a sidewall of a battery holder. Specifically, with reference to FIG. 3, FIG. 3 is a diagram of a structure of a tuning member that is disposed between a middle frame and a battery in an electronic device according to the conventional technologies. A specific spacing exists between a sidewall of a battery 201 and a middle frame 205 (an antenna radiator). A side plate 202 is disposed at the sidewall of the battery 201. A circuit board 203 is disposed between the side plate 202 and the middle frame 205 (the antenna radiator). A tuning member 204 is disposed on the circuit board 203. The tuning member 204 abuts against the middle frame 205 and the side plate 202 by using the elastic pieces 104. However, this solution of vertically inserting the side plate at the sidewall of the battery holder features squeezed space of the battery holder, a complex electrical connection form, a plurality of times of transferring, a small antenna clearance, and high costs.

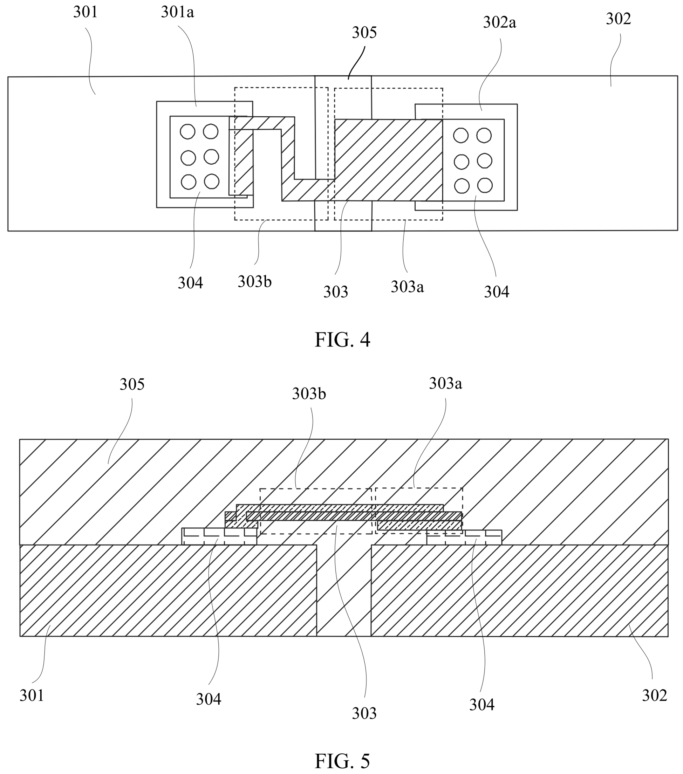

With reference to FIG. 4 and FIG. 5, FIG. 4 is a diagram of a structure of a connection between a metal frame antenna and a flexible circuit board in an electronic device according to the conventional technologies, and FIG. 5 is a sectional view of FIG. 4. An electronic device is further provided in the conventional technologies. The electronic device includes a first metal frame antenna 301, a second metal frame antenna 302, a flexible circuit board 303, and an injection molded piece 305. The injection molded piece 305 is disposed between the first metal frame antenna 301 and the second metal frame antenna 302. The first metal frame antenna 301 is provided with a first connection region 301a. The second metal frame antenna 302 is provided with a second connection region 302a. The flexible circuit board 303 includes a tuning part 303a and a redundancy part 303b. The redundancy part 303b is connected to the first connection region 301a through a connection plate 304. The tuning part 303a is connected to the second connection region 302a through a connection plate 304. An electrical connection structure of an antenna of the electronic device is as follows: A flexible circuit board is welded to a spot welding spring plate of a structural member, and then the spot welding spring plate is welded to a middle frame. A manufacturing process features a complex structure, and a supply chain involves a plurality of manufacturers, which causes problems of a long processing period and high costs.

This application discloses an electronic device. The electronic device includes a metal frame antenna component, a metal component, and a tuning component. A spacing exists between the metal component and the metal frame antenna component. An injection molded piece or another non-conductive component may be disposed in the spacing, or an air medium may be in the spacing. Two ends of the tuning component are respectively electrically connected to the metal frame antenna component and the metal component through welding and adhesion. The tuning component includes an equivalent device region and a plurality of welding regions. The plurality of welding regions are separately located on the two ends of the equivalent device region. The welding region on one end of the equivalent device region is welded to the metal frame antenna component, and the welding region on the other end of the equivalent device region is welded to the metal component. The tuning component includes a metal layer and an anti-oxidation layer that are laminated. Alternatively, the tuning component includes a silver paste layer. The metal component is the metal frame antenna component or a reference ground metal component.

In this application, the tuning component adjusts a resonance frequency of an antenna radiator, to ensure that the antenna can work normally. In addition, the two ends of the tuning component are directly electrically connected to the metal frame antenna component and the metal component through welding, so that an electrical connection structure of the tuning component and the metal component features small occupied space, a simple electrical connection manner, and a small antenna clearance.

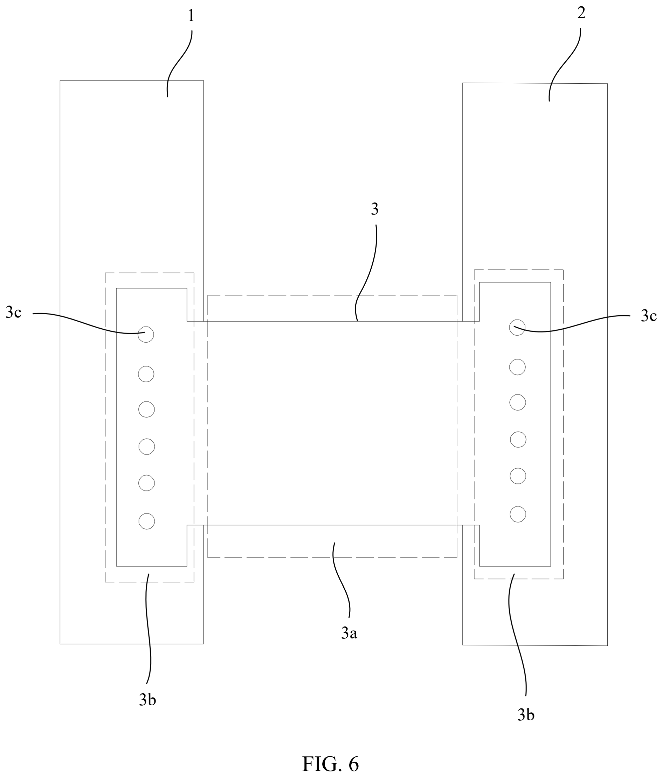

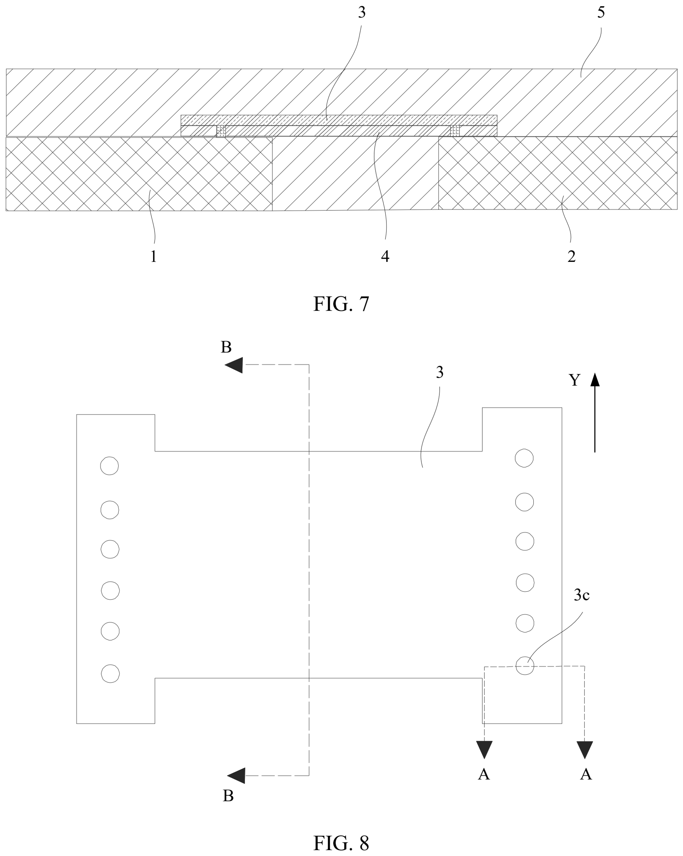

With reference to FIG. 6 and FIG. 7, FIG. 6 is a diagram of a structure of a connection between a metal component and a tuning component in an electronic device according to an embodiment of this application, and FIG. 7 is a sectional view of FIG. 6. An embodiment of this application discloses an electronic device. The electronic device includes a metal frame antenna component 1, a metal component 2, and a tuning component 3. A spacing exists between the metal component 2 and the metal frame antenna component 1. In this embodiment, an injection molded piece 5 is disposed between the metal component 2 and the metal frame antenna component 1. The tuning component 3 includes an equivalent device region 3a and two welding regions 3b. The two welding regions 3b are respectively located on two ends of the equivalent device region 3a. The two welding regions 3b are respectively welded to the metal frame antenna component 1 and the metal component 2. The two welding regions 3b are further bonded to the metal frame antenna component 1 and the metal component 2 by using an insulating double-sided adhesive 4. To be specific, one of the welding regions 3b is welded and bonded to the metal frame antenna component 1, and the other one of the welding regions 3b is welded and bonded to the metal component 2, to implement an electrical connection between the tuning component 3 and each of the metal frame antenna 1 and the metal component 2.

In this application, the welding regions are separately disposed on the two ends of the equivalent device region, so that the tuning component can be directly welded to the metal frame antenna component and the metal component through the welding regions. This has a simple connection structure, occupies small space, and facilitates a compact design of the electronic device. In addition, in this embodiment, the welding regions are further connected to the metal frame antenna component and the metal component through adhesion, so that the tuning component can be more stably connected to the metal frame antenna component and the metal component.

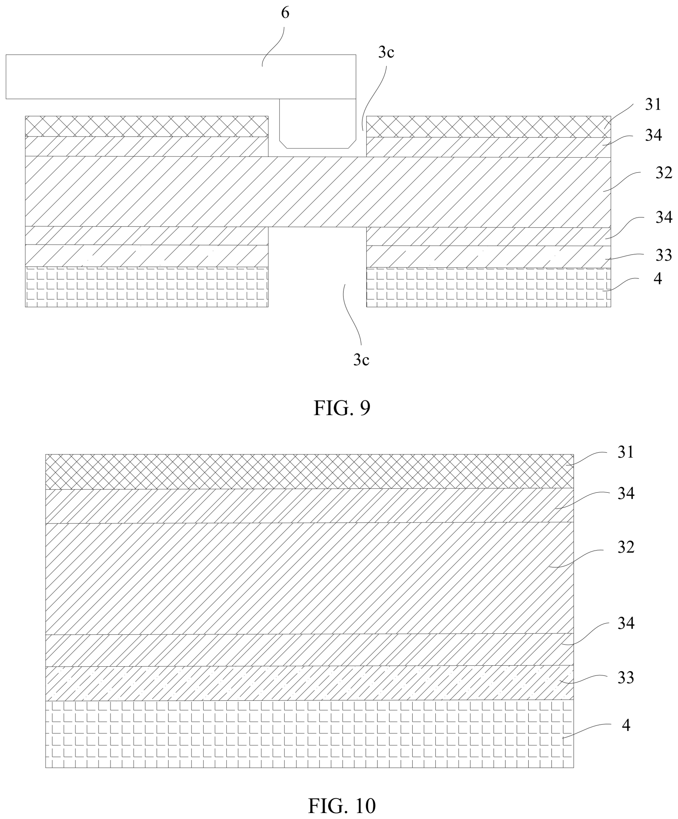

With reference to FIG. 8 to FIG. 10, FIG. 8 is a top view of a tuning component in an electronic device according to an embodiment of this application, FIG. 9 is a sectional view of FIG. 8 along A-A, and FIG. 10 is a sectional view of FIG. 8 along B-B. The tuning component 3 includes a strengthening layer 33, a metal layer 32, and an anti-oxidation layer 31 that are laminated. The strengthening layer 33 is connected through adhesion to a side that is of the metal layer 32 and that faces the metal frame antenna component 1 and the metal component 2. The anti-oxidation layer 31 is connected through adhesion to a side that is of the metal layer 32 and that faces away from the strengthening layer 33, to prevent, by using the anti-oxidation layer 31, the metal layer 32 from being oxidated due to exposure to the air and improve reliability of the electronic device by using the strengthening layer 33. For example, when the electronic device falls, the metal layer of the tuning component may be broken or partially deformed. By disposing the strengthening layer on a surface of the metal layer, reliability of the metal layer can be improved by using an anti-tension capability of the strengthening layer. In this embodiment, the strengthening layer 33 is bonded to the side of the metal layer 32 by using a back adhesive 34 on the strengthening layer 33, and the anti-oxidation layer 31 is bonded, by using a back adhesive 34 on the anti-oxidation layer 31, to the side that is of the metal layer 32 and that faces away from the strengthening layer 33.

Further, the two welding regions 3b are further respectively bonded to the metal frame antenna component 1 and the metal component 2 by using the insulating double-sided adhesive 4. To be specific, a side that is one of the welding regions 3b and that faces the metal frame antenna component 1 is bonded to and fastened to the metal frame antenna component 1, and a side that is of the other one of the welding regions 3b and that faces the metal component 2 is bonded to and fastened to the metal component 2. In this embodiment, the two welding regions 3b are respectively bonded to the metal frame antenna component 1 and the metal component 2, so that the tuning component 3 is more stably connected to each of the metal frame antenna component 1 and the metal component 2.

In some embodiments, the anti-oxidation layer 31 may be made of a thin polyester film (Mylar), ink, or the like, and a thickness of the anti-oxidation layer 31 may be any thickness according to different use requirements. For example, the thickness of the anti-oxidation layer 31 may be 0.01 $\mu$m. A material of the metal layer 32 may be copper foil, aluminum foil, silver foil, gold foil, or the like. A thickness of the metal layer 32 may be any thickness according to different use requirements. For example, a thickness of conventional copper foil may be 18 $\mu$m or 27 $\mu$m. A material of the strengthening layer 33 may be polyimide (PI), a thin polyester film (Mylar), fiberglass cloth (FR4), or the like. A thickness of the strengthening layer 33 may be any thickness according to different use requirements. For example, the thickness of the strengthening layer 33 may be 0.01 $\mu$m. A thickness of the insulating double-sided adhesive 4 may be 0.01 $\mu$m.

In some embodiments, the strengthening layer may be alternatively not disposed. Whether to dispose the strengthening layer may be determined according to an actual use condition in an entire system. If the strengthening layer is disposed, because the strengthening layer has the back adhesive, the welding regions of the tuning component can be directly bonded to the metal frame antenna component and the metal component by using the strengthening layer. If no strengthening layer is disposed, a back adhesive layer may be disposed, and the welding regions of the tuning component may be bonded to the metal frame antenna component and the metal component by using the back adhesive layer.

With reference to FIG. 9, a welding position 3c is disposed in the welding region 3b. At the welding position 3c, a surface that is of the metal layer 32 and that faces the anti-oxidation layer 31 can be exposed outside the anti-oxidation layer 31 through the welding position 3c, and a surface that is of the metal layer 32 and that faces the strengthening layer 33 can be exposed outside the strengthening layer 33 through the welding position 3c. In this way, a welding tip 6 can pass through the welding position 3c to perform a welding operation, so that the metal layer 32 at the welding position 3c is welded to the metal frame antenna component 1 and the metal component 2, thereby improving welding effect.

Still with reference to FIG. 8, a plurality of welding positions 3c are disposed in each welding region 3b, and the plurality of welding positions 3c are spaced along a length extension direction (a Y direction in FIG. 8) of the welding region 3b. All the welding positions 3c can be welded to the metal frame antenna component 1 and the metal component 2. In this embodiment, the plurality of welding positions 3c are disposed in each welding region 3b, and the metal layer 32 in each welding region 3b is welded to the metal frame antenna component 1 and the metal component 2, so that the tuning component 3 is more stably connected to the metal frame antenna component 1 and the metal component 2, thereby ensuring electrical connection stability between the tuning component and each of the metal frame antenna component and the metal component.

In this embodiment, the equivalent device region 3a and the welding region 3b are integrally disposed. To be specific, the equivalent device region 3a and the welding region 3b each include the strengthening layer 33, the metal layer 32, and the anti-oxidation layer 31 that are laminated. A difference between the equivalent device region 3a and the welding region 3b lies in that the welding position 3c needs to be disposed in the welding region 3b, and the welding position does not need to be disposed in the equivalent device region 3a.

In this embodiment, the welding regions 3b are welded to same sides of the metal frame antenna component 1 and the metal component 2 through ultrasonic welding. It may be understood that in another embodiment, the welding regions are welded to the metal frame antenna component and the metal component through spot welding, laser filling, or the like.

One or more metal layers of the equivalent device region 3a may be formed as required. In some embodiments, the equivalent device region 3a can be equivalent to a capacitor or an inductor. When the equivalent device region 3 is equivalent to a capacitor, the tuning component 3 further includes a dielectric layer. The equivalent device region 3a includes at least two metal layers, and the dielectric layer is located between the metal layers, so that the metal layers and the dielectric layer sandwiched between the metal layers form a large capacitor. A capacitance value of the equivalent device region may be calculated according to the following parallel plate capacitor calculation formula.

$$C = \frac{\varepsilon S}{D}$$

Herein, C is a capacitance value of a capacitor, $\varepsilon$ is a dielectric constant, that is, a dielectric constant of a substrate of a conventional flexible circuit board, S is an area of a metal layer, and D is a spacing between two metal layers. A capacitance value of a coupling capacitor may be adjusted by changing $\varepsilon$, S, and D. For example, when $\varepsilon$ is the dielectric substrate of the conventional flexible circuit board, D is a minimum distance between two metal layers that can form a capacitor, and S is 3 mm*5 mm, the capacitance value of the capacitor formed by the metal layers and the substrate has a maximum value of 10 pf. When $\varepsilon$ is increased, the capacitance value of the capacitor may be increased or the area of the metal layer of the capacitor may be decreased.

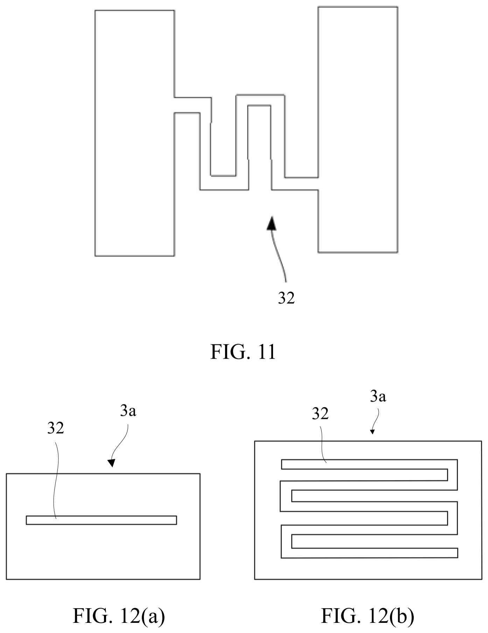

With reference to FIG. 11 to FIG. 12(b), FIG. 11 is a diagram of a structure of a metal layer, and FIG. 12(a) and FIG. 12(b) each are a diagram of a structure of an equivalent device region at a metal layer according to another embodiment of this application. When the equivalent device region 3a is equivalent to an inductor, the metal layer of the equivalent device region 3a may be set to a straight line or a serpentine line, and the equivalent device region 3a may be equivalent to an inductor of 1 nH to 8.8 nH.

According to different requirements, a metal layer structure of the equivalent device region may be processed through die cutting, etching, or the like. For example, if the equivalent device region includes two metal layers (a high DK dielectric material may be nest cut between two metal layers, where DK means a dielectric constant), a die cutting processing manner may be used. This processing manner has relatively low size processing sensibility. Costs can be reduced through die cutting. If the equivalent device region is an equivalent inductor, and line width consistency is highly required, an etching process may be used. In addition, the tuning component in this application has a simple structure. Therefore, the tuning component may be welded by using an auxiliary material resource of a die cutting factory. Alternatively, a conventional FPC antenna of an antenna factory (a lamination structure of a welding region is finely adjusted, that is, a welding part is led out) may be used. In other words, a solid component may also be welded in the equivalent device region, and then glue dispensing is performed for protection.

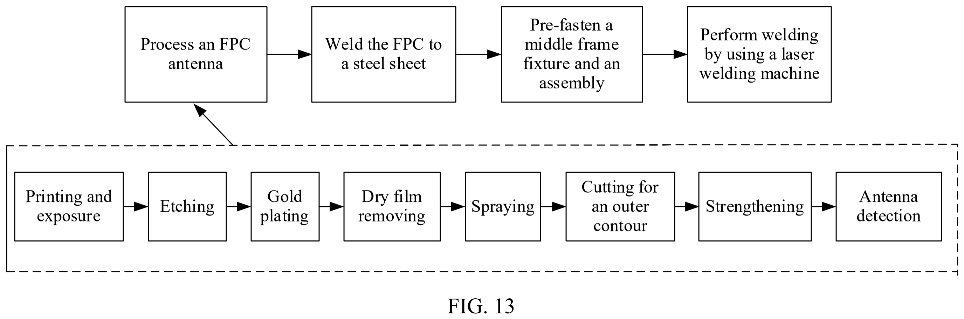

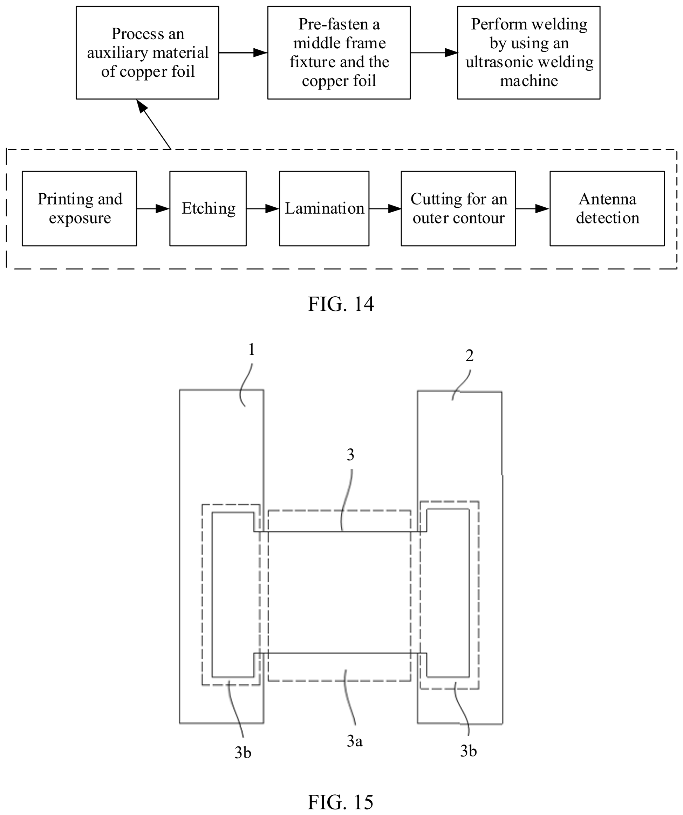

With reference to FIG. 13 and FIG. 14, FIG. 13 shows a process of manufacturing a connection between a metal frame antenna and a flexible circuit board in an electronic device according to the conventional technologies, and FIG. 14 shows a process of manufacturing a connection between a metal component and a tuning component in an electronic device according to an embodiment of this application. In the conventional technologies, a processing procedure of an electrical connection structure of an antenna is as follows: An FPC antenna is first manufactured by using a process: printing and exposure-etching-gold plating-dry film removing-spraying-cutting for an outer contour-strengthening-antenna detection. Then an FPC antenna is welded to a steel sheet. Pre-fastening is performed for a middle frame fixture and an assembly of the FPC antenna and the steel sheet. Finally, the assembly of the FPC antenna and the steel sheet is welded to and fastened to a middle frame by using a laser welding machine. A processing procedure of an electrical connection structure of an antenna in this embodiment is as follows: Copper foil (a tuning component) is first manufactured by using a process: printing and exposure-etching-lamination-cutting for an outer contour-antenna detection. Then pre-fastening is performed for the copper foil and the middle frame fixture. The copper foil is welded to and fastened to a middle frame by using an ultrasonic welding machine. A processing manner of the copper foil (the tuning component) in this application is different from that in the conventional technologies. In terms of resource fields, processing needs to be performed in an antenna factory in the conventional technologies, while processing may be performed in an auxiliary material factory in this application, that is, manufacturability is reduced. In addition, a processing process may be omitted.

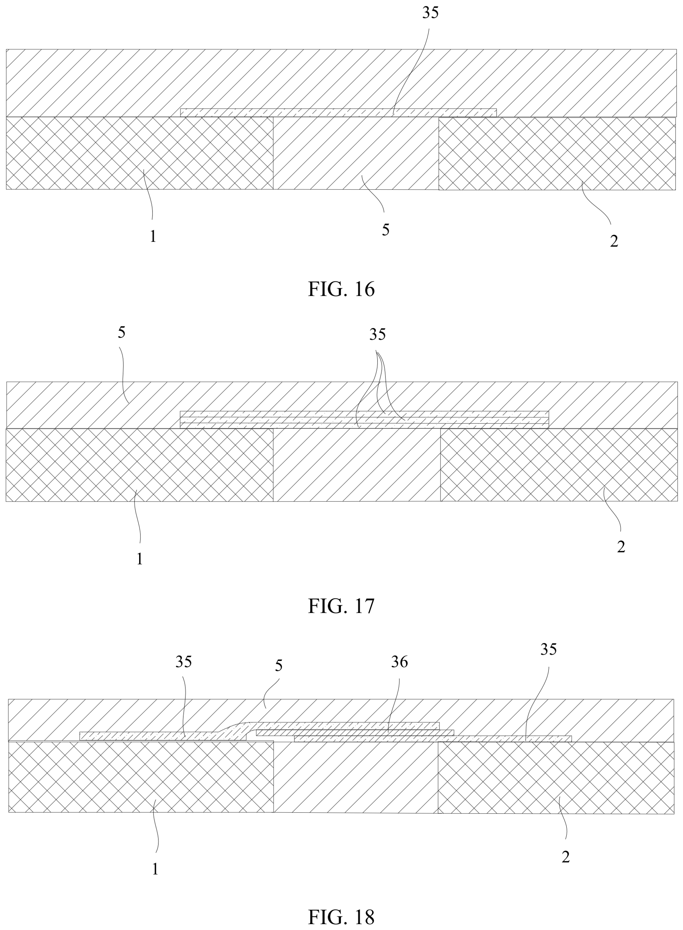

In some other embodiments, with reference to FIG. 15 to FIG. 17, FIG. 15 is a diagram of a structure of a connection between a metal component and a tuning component in an electronic device according to another embodiment of this application; FIG. 16 is a sectional view of FIG. 15; and FIG. 17 is a sectional view of a connection between a metal component and a tuning component in an electronic device according to still another embodiment of this application. The tuning component 3 may also include a silver paste layer 35. One or more silver paste layers 35 may be provided as required. The silver paste layer 35 is usually manufactured through a plurality of times of printing, for example, through printing-drying-printing-drying. In this case, the welding regions 3b of the tuning component 3 may be welded to the metal frame antenna component 1 and the metal component 2 through pad printing or spraying, to implement an electrical connection between the tuning component 3 and each of the metal frame antenna component 1 and the metal component 2.

When the equivalent device region 3a is equivalent to an inductor, the silver paste layer of the equivalent device region 3a is disposed as a silver paste wiring. A corresponding shape of the silver paste wiring may be formed by using a customized-shape indenter. To be specific, a required wiring shape is directly formed by using the customized-shape indenter. Alternatively, a corresponding shape of the silver paste wiring may be formed by removing an excessive region of the entire silver paste layer through laser carving. To be specific, an entire metal layer is first formed, and then an unnecessary region of the entire metal layer is removed through laser carving, to form a required wiring shape.

With reference to FIG. 18, FIG. 18 is a sectional view of a connection between a metal component and a tuning component in an electronic device according to still another embodiment of this application. When the equivalent device region 3a is equivalent to a capacitor, the tuning component 3 further includes a dielectric layer 36. A plurality of silver paste layers 35 are disposed. The dielectric layer 36 is disposed between the silver paste layers 35. In this way, the silver paste layers 35 and a dielectric sandwiched between the silver paste layers 35 form a capacitor. The dielectric may be a dielectric with a substrate. A dielectric constant and a thickness of the dielectric layer 36 may be adjusted based on a required capacitance value in actual application. In this embodiment, the tuning component 3 includes two silver paste layers 35 and one dielectric layer 36. One silver paste layer 35 is welded to the metal frame antenna component 1, and the other silver paste layer 35 is welded to the metal component 2. A dielectric layer 36 is disposed between the two silver paste layers 35. In other words, there is no direct connection point (no short-circuit point is allowed) between the two silver paste layers 35.

The foregoing descriptions are merely preferred specific implementations of this application, but are not intended to limit the protection scope of this application. Any modification or replacement readily figured out by a person skilled in the art within the technical scope disclosed in this application shall fall within the protection scope of this application. Therefore, the protection scope of this application shall be subject to the protection scope of the claims.

## Claims

1. An electronic device, comprising:

   a metal frame antenna component;
   a metal component, wherein a spacing exists between the metal component and the metal frame antenna component; and
   a tuning component, wherein the tuning component comprises an equivalent device region and a plurality of welding regions, the plurality of welding regions are separately located on two ends of the equivalent device region, the welding region on one end of the equivalent device region is welded to the metal frame antenna component, and the welding region on the other end of the equivalent device region is welded to the metal component, and the equivalent device region and the welding regions are integrally disposed.

2. The electronic device according to claim 1, wherein the welding region on the end of the equivalent device region is further connected to the metal frame antenna component through adhesion, and the welding region on the other end of the equivalent device region is further connected to the metal component through adhesion.

3. The electronic device according to claim 1, wherein the equivalent device region and the welding region each comprise a metal layer and an anti-oxidation layer that are laminated, and the anti-oxidation layer is disposed on a side that is of the metal layer and that faces away from the metal frame antenna component and the metal component.

4. The electronic device according to claim 3, wherein the equivalent device region and the welding region each further comprise a strengthening layer, and the strengthening layer is disposed on a side that is of the metal layer and that faces the metal frame antenna component and the metal component.

5. The electronic device according to claim 4, wherein a welding position is disposed in the welding region; and at the welding position, the side that is of the metal layer and that faces the anti-oxidation layer can be exposed outside the anti-oxidation layer through the welding position, and the side that is of the metal layer and that faces the strengthening layer can be exposed outside the strengthening layer through the welding position.

6. The electronic device according to claim 5, wherein there are a plurality of welding positions, and the plurality of welding positions are spaced along a length extension direction of the equivalent device region.

7. The electronic device according to claim 4, wherein the strengthening layer is connected to one side of the metal layer through adhesion, and the anti-oxidation layer is connected to the other side of the metal layer through adhesion.

8. The electronic device according to claim 4, wherein a material of the anti-oxidation layer is a thin polyester film or ink; or

   a material of the metal layer is copper foil, aluminum foil, silver foil, or gold foil; or
   a material of the strengthening layer is polyimide, a thin polyester film, or fiberglass cloth.

9. The electronic device according to claim 1, wherein the welding region is welded to the metal frame antenna component or the metal component through ultrasonic welding, spot welding, or laser filling.

10. The electronic device according to any one of claims 1 to 9, wherein the equivalent device region can be equivalent to a capacitor or an inductor.

11. An electronic device, comprising:

    a metal frame antenna component;
    a metal component, wherein a spacing exists between the metal component and the metal frame antenna component; and
    a tuning component, wherein the tuning component comprises an equivalent device region and a plurality of welding regions, the plurality of welding regions are separately located on two ends of the equivalent device region, the welding region on one end of the equivalent device region is welded to the metal frame antenna component, and the welding region on the other end of the equivalent device region is welded to the metal component, and
    the tuning component comprises a silver paste layer.

12. The electronic device according to claim 11, wherein the welding region is welded to the metal frame antenna component and the metal component through pad printing or spraying.

13. The electronic device according to claim 11, wherein the welding region on the end of the equivalent device region is further connected to the metal frame antenna component through adhesion, and the welding region on the other end of the equivalent device region is further connected to the metal component through adhesion.

14. The electronic device according to claim 11, wherein the equivalent device region can be equivalent to a capacitor or an inductor.

15. The electronic device according to claim 14, wherein when the equivalent device region is equivalent to an inductor, a silver paste layer of the equivalent device region is disposed as a silver paste wiring.

16. The electronic device according to claim 15, wherein a corresponding shape of the silver paste wiring is formed by using a customized-shape indenter, or a corresponding shape of the silver paste wiring is formed by removing an excessive region of the entire silver paste layer through laser carving.

17. The electronic device according to claim 14, wherein when the equivalent device region is equivalent to a capacitor, the tuning component further comprises a dielectric layer, a plurality of silver paste layers are disposed, and the dielectric layer is disposed between the silver paste layers.

102

C

D

101

FIG. 1

FIG. 2

205 203 202 201

206

204

206

FIG. 3

301   301a          305                    302a          302

304   303b   303   303a   304

FIG. 4

305          303b          303a

301   304   303   304   302

FIG. 5

FIG. 6

FIG. 7

FIG. 8

FIG. 9

FIG. 10

FIG. 11

FIG. 12(a)          FIG. 12(b)

```
┌──────────────┐     ┌──────────────┐     ┌──────────────┐     ┌──────────────┐
│  Process an  │     │ Weld the FPC │     │ Pre-fasten a │     │Perform welding│
│ FPC          │ ──> │ to           │ ──> │ middle frame │ ──> │ by using a   │
│ antenna      │     │ a steel sheet│     │ fixture and an│    │ laser        │
│              │     │              │     │ assembly     │     │welding machine│
└──────────────┘     └──────────────┘     └──────────────┘     └──────────────┘
        ↑
```

┌─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┐

| Printing and exposure | → | Etching | → | Gold plating | → | Dry film removing | → | Spraying | → | Cutting for an outer contour | → | Strengthening | → | Antenna detection |

└─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┘

FIG. 13

| Process an auxiliary material of copper foil | → | Pre-fasten a middle frame fixture and the copper foil | → | Perform welding by using an ultrasonic welding machine |

| Printing and exposure | → | Etching | → | Lamination | → | Cutting for an outer contour | → | Antenna detection |

FIG. 14

FIG. 15

FIG. 16

FIG. 17

FIG. 18

## INTERNATIONAL SEARCH REPORT

| | International application No. |
|---|---|
| | **PCT/CN2024/075496** |

| A. | CLASSIFICATION OF SUBJECT MATTER |
|---|---|

H01Q1/20(2006.01)i; H01Q1/22(2006.01)i; H01Q1/24(2006.01)i

According to International Patent Classification (IPC) or to both national classification and IPC

| B. | FIELDS SEARCHED |
|---|---|

Minimum documentation searched (classification system followed by classification symbols)

IPC: H01Q

Documentation searched other than minimum documentation to the extent that such documents are included in the fields searched

Electronic data base consulted during the international search (name of data base and, where practicable, search terms used)

CNTXT, ENTXTC, ENTXT, DWPI, CJFD, CNKI: 荣耀终端, 胡文龙, 天线, 柔性, 电路板, 调谐, 谐振, 等效, 一体, 补强, 金属层, 抗氧化, 聚酰亚胺, 聚酯, 玻璃纤维布, 焊接, 焊合, 点焊, 缝焊, 电焊, 焊缝, 焊点, 银, antenna?, flexible, circuit board?, tuning, resonance, equivalent, integral, reinforce+, metal layer?, oxidation resistant, polyimide, polyester, fiberglass, solder+, weld+, silver, Ag

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 116887551 A (HONOR DEVICE CO., LTD.) 13 October 2023 (2023-10-13) description, paragraphs [0003]-[0020] and [0044]-[0067], and figures 1-18 | 1-3, 9-14 |
| X | CN 213753021 U (HONOR DEVICE CO., LTD.) 20 July 2021 (2021-07-20) description, paragraphs [0045]-[0060], and figures 3-11 | 1-3, 9-14 |
| X | CN 216055141 U (HONOR DEVICE CO., LTD.) 15 March 2022 (2022-03-15) description, paragraphs [0039]-[0058], and figures 3-11 | 1-3, 9-14 |
| A | CN 113054401 A (HONOR DEVICE CO., LTD.) 29 June 2021 (2021-06-29) entire document | 1-17 |
| A | CN 213660613 U (KUNSHAN INNOWAVE COMMUNICATION TECHNOLOGY CO., LTD.) 09 July 2021 (2021-07-09) entire document | 1-17 |
| A | CN 219610740 U (BEIJING XIAOMI MOBILE SOFTWARE CO., LTD.) 29 August 2023 (2023-08-29) entire document | 1-17 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **27 May 2024** | **31 May 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2024/075496**

### C.    DOCUMENTS CONSIDERED TO BE RELEVANT

| Category* | Citation of document, with indication, where appropriate, of the relevant passages | Relevant to claim No. |
|---|---|---|
| A | US 2016218422 A1 (SAMSUNG ELECTRONICS CO., LTD.) 28 July 2016 (2016-07-28) entire document | 1-17 |
| A | US 5463404 A (E-SYSTEMS, INC.) 31 October 1995 (1995-10-31) entire document | 1-17 |

Form PCT/ISA/210 (second sheet) (July 2022)

### INTERNATIONAL SEARCH REPORT
**Information on patent family members**

International application No.

**PCT/CN2024/075496**

| Patent document cited in search report | | | Publication date (day/month/year) | Patent family member(s) | | | Publication date (day/month/year) |
|---|---|---|---|---|---|---|---|
| CN | 116887551 | A | 13 October 2023 | CN | 116887551 | B | 12 December 2023 |
| CN | 213753021 | U | 20 July 2021 | None | | | |
| CN | 216055141 | U | 15 March 2022 | None | | | |
| CN | 113054401 | A | 29 June 2021 | CN | 113054401 | B | 05 April 2022 |
| | | | | WO | 2022213698 | A1 | 13 October 2022 |
| CN | 213660613 | U | 09 July 2021 | None | | | |
| CN | 219610740 | U | 29 August 2023 | None | | | |
| US | 2016218422 | A1 | 28 July 2016 | KR | 20160092608 | A | 05 August 2016 |
| | | | | KR | 102294019 | B1 | 26 August 2021 |
| | | | | US | 10461411 | B2 | 29 October 2019 |
| US | 5463404 | A | 31 October 1995 | None | | | |

Form PCT/ISA/210 (patent family annex) (July 2022)

**EP 4 726 916 A1**

**Patent documents cited in the description**

- CN 202311146409X